# FASCICULE DE BREVET EUROPEEN

(11) **EP 0 634 376 B1**
(45) Date de publication et mention de la délivrance du brevet: **28.05.1997**
(21) Numéro de dépôt: 94401608.8
(22) Date de dépôt: 12.07.1994
(51) Int. Cl.: C03C 17/245, C03C 17/36, C23C 14/58

(54) **Procédé de traitement d'une couche mince d'oxyde**
Verfahren zur Behandlung einer dünnen Oxidschicht
Process for treating a thin oxide layer

(30) Priorité: 15.07.1993 DE 4323654
(43) Date de publication de la demande: 18.01.1995
(73) Titulaire: SAINT-GOBAIN VITRAGE, 92400 Courbevoie (FR)
(72) Inventeur: Schitcht, Heinz, Dr., D-06925 Bethau (DE); Schlindler, Herbert, D-04860 Torgau (DE); Januschkewitz, Klaus, D-53773 Hennef (DE); Gregorowius, Werner, D-51143 Köln (DE); Kaiser, Wilfried, D-04860 Torgau (DE)
(74) Mandataire: Muller, René

(56) Documents cités:
- PATENT ABSTRACTS OF JAPAN vol. 13, no. 532 (C-659) 28 Novembre 1989 & JP-A-01 215 963 (HITACHI LTD) 29 Août 1989
- PATENT ABSTRACTS OF JAPAN vol. 14, no. 105 (E-895) 26 Février 1990 & JP-A-01 307 283 (MATSUSHITA ELECTRIC IND CO LTD) 12 Décembre 1989
- PATENT ABSTRACTS OF JAPAN vol. 13, no. 160 (E-744) 18 Avril 1989 & JP-A-63 314 715 (MATSUSHITA ELECTRIC IND CO LTD) 22 Décembre 1988
- THIN SOLID FILMS., vol.102, no.1, Avril 1983, LAUSANNE CH pages 1 - 46 K.L.CHOPRA ET AL 'Transparent Conductors- A Status Review'

## Description

L'invention concerne les couches minces déposées sous vide en particulier celles qui comprennent un oxyde métallique obtenu par pulvérisation cathodique sur un substrat comme le verre et spécialement, les ensembles de couches comprenant de l'argent telles que des couches à basse émissivité. Elles concernent précisément un procédé d'amélioration et de stabilisation de ces couches.

Les systèmes de couches qui sont obtenus par une technique sous vide présentent souvent des caractéristiques insuffisantes en ce qui concerne leur tenue mécanique et chimique. Ces limitations dans les performances sont en particulier observées dans les systèmes qui comportent une ou plusieurs couches avec un oxyde métallique semi-conducteur de type n comme par exemple les couches à base d'oxyde d'étain. On peut trouver plusieurs causes à une telle sensibilité accrue des couches superficielles. C'est ainsi que le procédé de pulvérisation cathodique réactif entraîne de telles déficiences lorsque le rapport de l'argon et de l'oxygène dans le gaz dépasse une certaine valeur ou lorsque les gaz comportent des traces d'eau ou d'hydrocarbure ce qui ne peut pas toujours être évité dans les installations industrielles.

Il est connu que la tenue mécanique ou chimique de tels systèmes de couches peut être améliorée grâce à un traitement de stabilisation. Dans le document DD-B-272 971 on décrit un procédé de stabilisation de la couche superficielle en oxyde métallique par un traitement à l'atmosphère avec de l'eau saturée en oxygène. L'amélioration des performances obtenue par le traitement précédent s'explique par l'apauvrissement de la couche d'oxyde superficielle en molécules d'oxygène intersticielles. Selon un autre procédé connu décrit dans le document DD-B-281 819 on stabilise les systèmes de couches comportant un oxyde comme couche superficielle par un traitement dans des solutions aqueuses de chromates, de dichromates ou de permanganates. Ici aussi l'amélioration des performances des systèmes de couches s'interprète par un apauvrissement en oxygène de la couche superficielle.

Le document JP-A-1 215 963 décrit un procédé de formation d'une couche oxyde (supraconductrice) sur un substrat comprenant une méthode de dépôt sous vide (pulvérisation cathodique) et un traitement de chauffage à l'aide de rayonnements infrarouges.

Le document "Thin Solid Films, vol. 102, no. 1, 1983, pages 1-46, chapitre 2.2, décrit un procédé de dépôt d'une couche d'une oxyde métallique (p.e. ITO) sur un substrat en verre par la méthode de pulvérisation cathodique, suivi d'un traitement de chauffage après le dépôt pour obtenir les propriétés conductrices optimales.

Le document JP-A-63 314 715 décrit un procédé pour améliorer les propriétés électriques d'une couche d'oxyde métallique (ITO) par irradiation infrarouge.

L'invention se donne pour tâche de fournir un procédé d'amélioration des performances des couches d'oxyde superficielles qui soit facile à mettre en oeuvre et qui puisse en parliculier s'intégrer dans les procédés de fabrication habituels.

L'invention propose un procédé de fabrication d'un substrat comportant au moins une couche d'un oxyde métallique utilisant un procédé de dépôt sous vide tel que la pulvérisation cathodique, à l'issue duquel on procède à un traitement à effet thermique, caractérisé en ce que le traitement est un traitement de stabilisation de la couche d'oxyde métallique dans des conditions contrôlées et en ce qu'il comporte l'irradiation de la surface du substrat avec de la lumière infrarouge de longueur d'onde supérieure à 1,5 µm et en particulier avec un maximum d'environ 2,5 µm.

Une variante particulièrement efficace de l'invention consiste en l'utilisation de rayonnement infrarouge immédiatement après la fabrication.

Il est possible de faire varier de manière importante l'énergie utilisée pour le traitement. Elle doit être au minimum de 180 kJ/m² et au maximum 5400 kJ/m². Selon la durée du traitement qui est comprise de préférence entre quelques secondes et environ 5 minutes on obtient une puissance superficielle comprise entre 1 kW/m² et 90 kW/m². De préférence, le choix de la puissance de rayonnement doit être tel qu'on évite d'atteindre des températures du verre supérieures à 100°C. Dans le cas du verre, si on dépassait cette limite la manipulation des plaques de verre deviendrait délicate ce qui compliquerait l'intégration de la phase de stabilisation dans le procédé de production. Le procédé de l'invention s'applique lorsque la couche d'oxyde métallique est SnOₓ ou un oxyde semi-conducteur du type n ou appartenant au groupe comprenant les oxydes de silicium, d'aluminium, de magnésium, de zirconium, de niobium, de zinc, de tantale et de titane. Le procédé de l'invention mis en oeuvre à la fin du processus de fabrication sous vide produit une amélioration sensible des propriétés mécaniques et chimiques de la couche superficielle et/ou du système de couches complet comme il sera démontré à l'aide des exemples.

On peut trouver une explication du succès du traitement préconisé par l'invention dans le fait que dans les conditions pratiques de production industrielle d'oxydes métalliques c'est-à-dire avec un taux de pulvérisation élevé et une densité de plasma également importante la réaction n'est pas stoechiométrique et que sous l'influence du rayonnement infrarouge on provoque une réaction de polycondensation dans la couche d'oxyde superficielle qui entraîne une réticulation plus importante dans la couche.

Il est connu qu'immédiatement à la fin du procédé de pulvérisation cathodique les couches déposées sur le verre sont parfois relativement sensibles mais que leur contact avec l'atmosphère entraîne un processus de vieillissement qui a pour conséquence naturelle de rendre les couches plus dures et moins sensibles. Ce processus de vieillissement naturel s'étend sur plusieurs jours et ne peut se produire que si la couche est en contact avec l'atmosphère. Dans les productions industrielles habituelles les plaques de verre sur lesquelles les couches ont été déposées sont empilées en général immédiatement à la sortie de l'installation et le plus souvent immédiatement empaquetées de manière étanche ce qui interrrompt le contact de la couche avec l'atmosphère. Le vieillissement naturel bénéfique ne peut donc avoir lieu immédiatement et en particulier le transport des paquets de plaques de verre jusqu'au lieu d'exploitation se fait avant que l'amélioration, par exemple de la tenue mécanique ne protège les plaques contre une dégradation lorsque les vibrations du transport sollicitent mécaniquement les couches.

Le procédé de l'invention permet d'obtenir ce processus de stabilisation dans des conditions contrôlées et dans des temps très brefs simplement par l'utilisation de rayonnement infrarouge en présence de l'atmosphère. On peut ainsi insérer cette phase supplémentaire dans le processus normal sans que sa durée soit sensiblement allongée. A l'issue du processus de stabilisation les couches superficielles présentent une dureté superficielle sensiblement améliorée si bien que, même si les plaques sont immédiatement assemblées en paquets où elles sont serrées les unes contre les autres, le transport qui suit avec ses vibrations ne les dégrade pas.

Le procédé de l'invention et les améliorations de qualité des couches qu'il entraîne seront expliquées en détail grâce aux exemples qui suivent, dans lesquels un système de couches à basse émissivité sur des plaques de verre flotté comporte une couche superficielle à base SnOₓ déposée par pulvérisation cathodique réactive assistée par champ magnétique.

Pour apprécier la qualité d'un système de couches on fait appel à une méthode utilisant 〈〈 l'angle de raccordement〉〉 telle qu'elle figure dans l'ouvrage 〈〈 Physikalische Chemie der Glasoberfläche 〉〉, Deutscher Verlag für Grundstoffindustrie, Leipzig, 1981. L'angle de raccordement, c'est-à-dire l'angle que fait un liquide au contact de la surface d'un solide fournit des indications qualitatives sur la composition, la structure et la morphologie de la surface du solide et en particulier du verre et permet de tirer des conclusions sur les modifications de surface et même sur la tenue de couches déposées sur le verre.

Par ailleurs, on utilise un test à l'acide nitrique pour évaluer la résistance chimique des couches. Dans celui-ci une goutte de HNO₃ (10 µl ; HNO₃ semi-concentré) est déposée sur la couche à une température de 21°C. Après dix minutes on mesure le diamètre de la tache de corrosion généralement circulaire qui apparaît. Plus le diamètre de cette tache est petit meilleure est la tenue chimique de la couche.

### EXEMPLE COMPARATIF

Sur une plaque de verre flotté on dépose une couche basse émissive de composition :

verre-SnOₓ (28 nm) - Ag (11 nm) - CrNiOₓ (4 nm)-SnOₓ (32 nm)

dans une installation de pulvérisation cathodique traversante. A la sortie de la ligne on prélève immédiatement des échantillons pour la mesure de l'angle de raccordement et pour le test nitrique.

Une plaque de verre avec sa couche a été stockée à l'air pendant 48 heures. On a alors prélevé et testé les mêmes échantillons que précédemment.

Par ailleurs, on a retiré au bout de 48 heures, une plaque qui avait été placée immédiatement à sa sortie de la ligne au coeur d'un empilement de plaques identiques. On a alors découpé dans cette plaque des échantillons identiques.

Les résultats des tests de l'angle de raccordement et de l'acide nitrique dans les trois cas sont rassemblés dans le tableau suivant.

| | sortie de ligne | 48 heures à l'air | 48 heures empilé |
|---|---|---|---|
| angle de raccordement (°) | 13 | 47 | 22 |
| test nitrique (cm) | 1,2 | 0,9 | 1,1 |

Les valeurs montrent que le processus de vieillissement naturel et donc d'amélioration de la qualité de la couche tel qu'il se produit lorsqu'on expose la couche à l'air pendant 48 heures est empêché lorsque la plaque de verre est empilée de telle manière que le contact de la couche avec l'atmosphère environnante soit gêné.

### EXEMPLE 1

A la suite du processus de production habituel, à la sortie de la ligne de pulvérisation cathodique et avant l'entrée dans l'empileuse automatique on a installé des radiateurs infrarouge dont la caractéristique de rayonnement possèdait un maximum à 2,5 µm. Les conditions étaient telles que la puissance de rayonnement était de 18 kW/m². La distance entre le radiateur et la surface de verre était de 120 mm.

On a prélevé quatre sortes d'échantillons différents, les uns directement à la sortie de la ligne avant le traitement radiatif, d'autres immédiatement après celui-ci, d'autres après un stockage à l'air de 48 heures et les derniers enfin après un stockage empilés pendant 48 heures également. On a procédé au même test que sur les échantillons de référence. Les résultats étaient les suivants :

| | avant irradiation | après irradiation | | |
|---|---|---|---|---|
| | sortie ligne | sortie ligne | 48 h à l'air | 48 h empilé |
| angle de raccordement (°) | 14 | 41 | 41 | 52 |
| test nitrique (cm) | 1,1 | 0,9 | 0,95 | 0,8 |

Les résultats des tests montrent une nette amélioration de la qualité de la couche grâce à l'irradiation infrarouge. Les résultats sont pratiquement inchangés à l'issue d'un stockage de 48 heures à l'air. On a même constaté une amélioration supplémentaire à l'issue d'un stockage de 48 heures dans une pile. Une vérification a permis de montrer que cette amélioration subsistait même après un stockage de 48 heures du même échantillon à l'air libre.

### EXEMPLE 2

Pour évaluer l'influence de la longueur d'onde du rayonnement infrarouge et de sa durée sur les résultats de la stabilisation on a procédé à des essais supplémentaires sur les mêmes échantillons que ceux décrits ci-dessus. On a soumis 10 échantillons à des conditions d'irradiation infrarouge diverses et chaque fois à l'issue de l'irradiation on a procédé à la mesure de l'angle de raccordement et au test HNO₃.

Les résultats sont les suivants :

| échantillon | longueur d'ondeIR (µm) | durée (mn) | température du verre (°C) | angle de raccordement (°) | test HNO₃ (cm) |
|---|---|---|---|---|---|
| 1 | - | - | - | 13 | 1,3 |
| 2 | 2,5 | O,5 | 39 | 27 | 1,2 |
| 3 | 2,5 | 1 | 52 | 31 | O,9 |
| 4 | 2,5 | 1,5 | 67 | 31 | O,9 |
| 5 | 2,5 | 2 | 75 | 30 | 1,O |
| 6 | 3,4 | O,5 | 41 | 22,5 | - |
| 7 | 3,4 | 1 | 54 | 26 | 1,2 |
| 8 | 3,4 | 1,5 | 60 | 26 | 1,1 |
| 9 | 3,4 | 2 | 85 | 26 | 1,2 |
| 10 | 1,8 | O,5 | 38 | 26,5 | 1,2 |
| 11 | 1,6 | 1 | 54 | 28 | 1,2 |

Les résultats montrent que la stabilisation est la meilleure lorsque le maximum de la longueur d'onde du rayonnement infrarouge est à 2,5 µm.

Les exemples précédents ont tous été réalisés avec comme couche superficielle une couche d'oxyde d'étain. Il est clair pour l'homme du métier cependant que des réactions identiques se produisent pour d'autres couches d'oxydes métalliques susceptibles comme SnOₓ d'être sous stoechiométriques à cause des conditions de production et de posséder des molécules d'oxygène ou d'eau interstitielles, ce sont en particulier les couches à base d'oxydes du type semi-conducteur n, et spécialement les oxydes de silicium, aluminium, magnésium, zirconium, niobium, zinc, tantale, et titane.

En effet, les couches minces obtenues avec ces oxydes ont selon les conditions de dépôt, de l'eau liée en quantité plus ou moins importante. Dans ces conditions, des réticulations de même nature que celles qu'on observe dans l'oxyde d'étain peuvent se produire qui conduisent à une stabilisation des couches.

## Revendications

1. Procédé de fabrication d'un substrat comportant au moins une couche d'un oxyde métallique utilisant un procédé de dépôt sous vide tel que la pulvérisation cathodique, à l'issue duquel on procède à un traitement à effet thermique, **caractérisé en ce que** le traitement est un traitement de stabilisation de la couche d'oxyde métallique dans des conditions contrôlées **et en ce qu'**il comporte l'irradiation de la surface du substrat avec de la lumière infra-rouge de longueur d'onde supérieure à 1,5 µm, en particulier avec un maximum d'environ 2,5 µm.

2. Procédé de fabrication selon la revendication 1, **caractérisé en ce que** l'irradiation du substrat est effectuée immédiatement à la sortie de la ligne de dépôt sous vide.

3. Procédé de fabrication selon l'une des revendications 1 ou 2, **caractérisé en ce que** le substrat est en verte flotté **et que** l'irradiation est effectuée avec une puissance comprise entre 1 kW/m² et 90 kW/m² de telle sorte que le substrat ne dépasse pas une température d'environ 100°C.

4. Procédé de fabrication selon l'une des revendications 1 à 3, **caractérisé en ce que** la durée de l'irradiation dépend de sa puissance et qu'elle est comprise entre 10 secondes et 5 minutes.

5. Procédé de fabrication selon l'une des revendications 1 à 4, **caractérisé en ce que** la couche d'oxyde métallique est SnOₓ ou un oxyde semi-conducteur du type n ou appartenant au groupe comprenant les oxydes de silicium, d'aluminium, de magnésium, de zirconium, de niobium, de zinc, de tantale et de titane.

## Claims

1. Method of producing a substrate comprising at least one metallic oxide film, using a deposition method under vacuum such as cathodic sputtering, after which a thermal treatment is carried out, characterized in that the treatment is a stabilization treatment for the film of metallic oxide under controlled conditions and in that it includes irradiation of the surface of the substrate with infrared light having a wavelength greater than 1.5 µm, in particular with a maximum of approximately 2.5 µm.

2. Production method according to claim 1, characterized in that the irradiation of the substrate is performed immediately after it has left the vacuum deposition line.

3. Production method according to one of claims 1 or 2, characterized in that the substrate is of float glass and the irradiation is performed with a power lying between 1 kW/m² and 90 kW/m², in such a way that the substrate does not exceed a temperature of approximately 100°C.

4. Production method according to one of claims 1 to 3, characterized in that the duration of the irradiation depends upon its power and that it lies between 10 seconds and 5 minutes.

5. Production method according to one of claims 1 to 4, characterized in that the metallic oxide film is of SnOₓ or a semiconductor oxide of the n type or belonging to the group comprising the oxides of silicon, aluminium, magnesium, zirconium, niobium, zinc, tantalum and titanium.

## Patentansprüche

1. Verfahren zur Herstellung eines wenigstens eine Metalloxidschicht aufweisenden Substrats unter Anwendung eines Vakuum-Beschichtungsverfahrens wie der Kathodenzerstäubung, mit einer anschließenden Wärmebehandlung, **dadurch gekennzeichnet**, daß die Wärmebehandlung eine Stabilisierungsbehandlung der Metalloxidschicht unter kontrollierten Bedingungen ist, und daß sie die Bestrahlung der Substratoberfläche mit infrarotem Licht einer Wellenlänge oberhalb von 1,5 µm umfaßt.

2. Verfahren zur Herstellung nach Anspruch 1, dadurch gekennzeichnet, daß die Bestrahlung des Substrats unmittelbar am Ausgang der Vakuum-Beschichtungslinie durchgeführt wird.

3. Verfahren zur Herstellung nach Anspruch 1 oder 2, dadurch gekennzeichnet, daß das Substrat eine Floatglasscheibe ist, und daß die Bestrahlung mit einer Bestrahlungsleistung von 1 kW/m² bis 90 kW/m² derart durchgeführt wird, daß das Substrat eine Temperatur von circa 100 °C nicht überschreitet.

4. Verfahren zur Herstellung nach einem der Ansprüche 1 bis 3, dadurch gekennzeichnet, daß die Dauer der Bestrahlung von der Bestrahlungsleistung abhängt und von 10 Sekunden bis 5 Minuten beträgt.

5. Verfahren zur Herstellung nach einem der Ansprüche 1 bis 4, dadurch gekennzeichnet, daß die Metalloxidschicht aus SnOₓ oder aus einem Metalloxid vom n-Halbleitertyp, oder aus der Gruppe der Oxide von Silizium, Aluminium, Magnesium, Zirkonium, Niob, Zink, Tantal oder Titan besteht.
